(19) Europäisches Patentamt
European Patent Office
Office européen des brevets

(11) **EP 4 123 686 A1**

(12) **EUROPEAN PATENT APPLICATION**
published in accordance with Art. 153(4) EPC

(43) Date of publication:
**25.01.2023 Bulletin 2023/04**

(21) Application number: **21771617.4**

(22) Date of filing: **08.02.2021**

(51) International Patent Classification (IPC):
**H01L 21/265** (2006.01)  **H01L 21/66** (2006.01)

(52) Cooperative Patent Classification (CPC):
**H01L 21/265; H01L 22/00**

(86) International application number:
**PCT/JP2021/004559**

(87) International publication number:
**WO 2021/186944 (23.09.2021 Gazette 2021/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **17.03.2020 JP 2020046938**

(71) Applicant: **Shin-Etsu Handotai Co., Ltd.**
**Tokyo 100-0004 (JP)**

(72) Inventor: **TAKENO, Hiroshi**
**Annaka-shi, Gunma 379-0196 (JP)**

(74) Representative: **Sonnenhauser, Thomas Martin**
**Wuesthoff & Wuesthoff**
**Patentanwälte PartG mbB**
**Schweigerstraße 2**
**81541 München (DE)**

(54) **METHOD FOR CONTROLLING DONOR CONCENTRATION IN SILICON SINGLE CRYSTAL SUBSTRATE**

(57) The present invention is a method for controlling a donor concentration in a silicon single crystal substrate, the method including: a first proton irradiation step of irradiating with protons a test silicon single crystal substrate before performing a second proton irradiation step; a hydrogen concentration measurement step of measuring a depth direction distribution of hydrogen concentrations in the test silicon single crystal substrate after the first proton irradiation step; a first heat treatment step of heating the test silicon single crystal substrate under conditions as in a second heat treatment step; a donor concentration measurement step of measuring a depth direction distribution of donor increments attained in the test silicon single crystal substrate after the first heat treatment step; and a correlation acquisition step of acquiring a correlation between the hydrogen concentrations and the donor increments in the test silicon single crystal substrate from the depth direction distribution of the hydrogen concentrations and the depth direction distribution of the donor increments. A dose of the protons radiated in the second proton irradiation step is adjusted based on the correlation such that a donor increment in a silicon single crystal substrate whose donor concentration is to be controlled reaches a target value after the second heat treatment step.

[FIG. 1]

| | |
|---|---|
| Preparation step (test silicon substrate) | S0 |
| First proton irradiation step (test silicon substrate) | S1 |
| Hydrogen concentration measurement step (test silicon substrate) | S2 |
| First heat treatment step (test silicon substrate) | S3 |
| Donor concentration measurement step (test silicon substrate) | S4 |
| Correlation acquisition step (test silicon substrate) | S5 |
| Second proton irradiation step (control-target silicon substrate) | S6 |
| Second heat treatment step (control-target silicon substrate) | S7 |

**Description**

TECHNICAL FIELD

The present invention relates to a method for controlling a donor concentration in a silicon single crystal substrate.

BACKGROUND ART

To increase speed and reduce loss of IGBT (Insulated Gate Bipolar Transistor) and diode for switching devices, a structure is utilized in which a field stop layer (or buffer layer) is formed on the back surface side of a thin wafer (Patent Document 1). Moreover, in order to have soft recovery characteristics also, a structure is proposed in which a broad buffer layer is formed substantially at the center in a thickness direction of a wafer, too (Patent Document 2).

As a method of forming a buffer layer or a broad buffer layer, there is a method in which donors are formed by proton irradiation and heat treatment. For example, Patent Document 1 discloses a method in which after a wafer is thinned, a buffer layer is formed by proton irradiation and heating (for example, 300°C to 500°C). Meanwhile, Patent Document 2 discloses a method in which a broad buffer layer is formed by proton irradiation at a proton dose of $1 \times 10^{11}$ atoms/cm$^2$ or more and $1 \times 10^{14}$ atoms/cm$^2$ or less and heating at 250°C or more and 500°C or less.

In the method of forming a buffer layer by proton irradiation and heating, a wide buffer layer can also be formed in a deep region in comparison with common cases of buffer layer formation by dopant ion implantation and activation heat treatment. Thus, improvement in device characteristics can be expected. Further, since donors can be formed by heating at low temperature, there is an advantage that problems such as cracking and scratching can be reduced in a process after the wafer is thinned.

Meanwhile, it is known that the concentration of donors formed by proton irradiation and heating is influenced by the concentrations of oxygen and carbon, which are light element impurities in a silicon single crystal substrate.

For example, Patent Document 2 states that the oxygen atom concentration in a region where a broad buffer layer is formed by proton irradiation and heating is desirably $1 \times 10^{16}$ atoms/cm$^3$ or more. Additionally, Non Patent Document 1 shows trends that the higher the oxygen concentration is, the higher the integrated donor concentration of the field stop layer formed by proton irradiation and heating, and also that the higher the carbon concentration is, the higher the integrated donor concentration.

As mentioned above, the concentration of donors formed by proton irradiation and heating is influenced by the concentrations of oxygen and carbon in a silicon single crystal substrate. Hence, the donor concentration varies depending on the silicon single crystal substrate in some cases.

The mechanism of donor formation by proton irradiation and heating is conceivably as follows. When a silicon single crystal substrate is irradiated with protons, hydrogen is introduced; simultaneously, a silicon atom at a lattice position is flicked out, and interstitial silicon (hereinafter referred to as I) and vacancy (hereinafter referred to as V) which is an empty shell thereof are produced. The excessively produced I or V is unstable when it is alone, so that they recombine (V+I->0), clustering of I's or V's occurs, or they react with a light element impurity such as oxygen or carbon contained in the silicon single crystal substrate to form a composite. Additionally, the cluster of I's or V's or the composite of I or V with a light element impurity combines with hydrogen by proton irradiation and heating, so that donors are formed conceivably. From these, it is presumed that multiple types of donors are formed by proton irradiation and heating, and that the types and concentrations vary depending on the concentration of light element impurities in the silicon single crystal substrate.

CITATION LIST

PATENT LITERATURE

Patent Document 1: JP 3684962 B2
Patent Document 2: JP 5104314 B2

NON PATENT LITERATURE

Non Patent Document 1: H. J. Schulze et al., Proceedings of the 2016 28th International Symposium on Power Semiconductor Devices and ICs (ISPSD), p.355.

SUMMARY OF INVENTION

TECHNICAL PROBLEM

The method of forming donors by proton irradiation and heating is an effective method for device characteristic improvement and process load reduction. Nevertheless, donors behave in a complex manner depending on the influences of intrinsic point defects (V, I) and light elements. These make it difficult to precisely control donor concentration.

Generally, it is believed that when the same proton acceleration voltage in proton irradiation and the same heating condition after the proton irradiation are employed, there is a monotonic relation between the concentration of donors formed by the proton irradiation followed by the heating and the proton dose in the proton irradiation. However, this is not always true in reality. There has been a problem that some work and cost are required to find out the proton dose for achieving a target donor concentration. Further, the concentration of donors formed by proton irradiation and heating differs also due to the concentrations of light element impurities in a silicon single crystal substrate. This also causes a problem that the donor concentrations vary depending on silicon single crystal substrates, even if the same proton irradiation and heating conditions are employed.

The present invention has been made in view of the problems as described above. An object of the present invention is to provide a method for controlling a donor concentration in a silicon single crystal substrate in such a manner to easily determine a proton dose for achieving a target donor concentration and successfully reducing a variation due to silicon single crystal substrates in a device manufacturing process in which donor concentration is controlled by proton irradiation and heating.

SOLUTION TO PROBLEM

The present invention has been made to achieve the object, and provides a method for controlling a donor concentration in a silicon single crystal substrate by performing:

a second proton irradiation step of irradiating with protons a silicon single crystal substrate whose donor concentration is to be controlled; and
a second heat treatment step of heating the silicon single crystal substrate after the second proton irradiation step, so that the donor concentration is controlled,
wherein the method comprises:

a first proton irradiation step of irradiating with protons a test silicon single crystal substrate in advance before performing the second proton irradiation step;
a hydrogen concentration measurement step of measuring a depth direction distribution of hydrogen concentrations in the test silicon single crystal substrate after the first proton irradiation step;
a first heat treatment step of heating the test silicon single crystal substrate after the first proton irradiation step under conditions as in the second heat treatment step;
a donor concentration measurement step of measuring a depth direction distribution of donor increments attained in the test silicon single crystal substrate after the first heat treatment step; and
a correlation acquisition step of acquiring a correlation between the hydrogen concentrations in the test silicon single crystal substrate and the donor increments attained in the test silicon single crystal substrate from the depth direction distribution of the hydrogen concentrations measured in the hydrogen concentration measurement step and the depth direction distribution of the donor increments measured in the donor concentration measurement step,
wherein a dose of the protons radiated in the second proton irradiation step is adjusted based on the acquired correlation such that a donor increment in the silicon single crystal substrate whose donor concentration is to be controlled reaches a target value after the second heat treatment step.

According to such a method for controlling a donor concentration in a silicon single crystal substrate, a correlation between hydrogen concentrations after a proton irradiation and donor increments in a test silicon single crystal substrate after the proton irradiation and a heat treatment is obtained in advance from the silicon single crystal substrate. Based on this correlation, proton dose in a proton irradiation on a silicon single crystal substrate whose donor concentration is to be controlled is adjusted to thereby control the donor concentration. These make it possible to easily determine a proton dose for precisely achieving a target donor concentration and successfully reducing a variation due to silicon single crystal substrates.

In this event, when the dose of the protons radiated in the second proton irradiation step is adjusted based on the correlation, the dose of the protons in the second proton irradiation step can be determined by utilizing:

a coefficient which is obtained from a dose of the protons in the first proton irradiation step and a maximum hydrogen concentration in the depth direction distribution of the hydrogen concentrations in the test silicon single crystal substrate; and

a hydrogen concentration which is obtained based on the correlation, and at which the donor increment in the silicon single crystal substrate reaches a target value after the second heat treatment step.

In this manner, the proton dose in the second proton irradiation step can be determined more accurately, and the donor increment in the silicon single crystal substrate after the second heat treatment step can reach a target value more closely.

In this event, the dose of the protons in the first proton irradiation step can be $1 \times 10^{14}$ atoms/cm$^2$ or more.

In the hydrogen concentration measurement step, for example, secondary ion mass spectrometry (SIMS) is available as a method of measuring the depth direction distribution of hydrogen concentrations in a silicon single crystal substrate. The depth direction distribution of hydrogen concentrations in a silicon single crystal substrate can be measured with high precision by SIMS and the like by setting the proton dose in the first proton irradiation step to $1 \times 10^{14}$ atoms/cm$^2$ or more.

In this event, the dose of the protons radiated in the second proton irradiation step can be adjusted for each crystal block.

In this manner, variation in donor concentration due to silicon single crystal substrates can be further reduced by controlling the donor concentration for each crystal block from which a silicon single crystal substrate whose donor concentration is to be actually controlled (control-target silicon single crystal substrate) is also obtained, or for each crystal block produced to satisfy the same specification.

ADVANTAGEOUS EFFECTS OF INVENTION

As described above, according to the inventive method for controlling a donor concentration in a silicon single crystal substrate, a correlation between hydrogen concentrations after a proton irradiation and donor increments after the proton irradiation followed by a heat treatment is obtained in advance from a test silicon single crystal substrate. Based on this correlation, the donor concentration can be controlled by adjusting proton dose in a proton irradiation. Thus, it is possible to easily determine a proton dose at which a target donor concentration is achieved and donor-concentration variation can be reduced regardless of silicon single crystal substrates.

BRIEF DESCRIPTION OF DRAWINGS

FIG. 1 is a chart illustrating an example of the inventive method for controlling a donor concentration in a silicon single crystal substrate.
FIG. 2 is a graph illustrating a depth direction distribution of hydrogen concentrations obtained in Example 1.
FIG. 3 is a graph illustrating a depth direction distribution of donor increments obtained in Example 1.
FIG. 4 is a graph illustrating a relation between the hydrogen concentrations and the donor increments obtained in Example 1.
FIG. 5 is a graph illustrating a depth direction distribution of donor increments obtained in Example 1.
FIG. 6 is a graph illustrating a depth direction distribution of hydrogen concentrations obtained in Example 2.
FIG. 7 is a graph illustrating a depth direction distribution of donor increments obtained in Example 2.
FIG. 8 is a graph illustrating a relation between the hydrogen concentrations and the donor increments obtained in Example 2.
FIG. 9 is a graph illustrating a depth direction distribution of donor increments obtained in Example 2.
FIG. 10 is a graph illustrating a depth direction distribution of hydrogen concentrations obtained in Example 3.
FIG. 11 is a graph illustrating a depth direction distribution of donor increments obtained in Example 3.
FIG. 12 is a graph illustrating a relation between the hydrogen concentrations and the donor increments obtained in Example 3.
FIG. 13 is a graph in which a border line between the front surface side and the back surface side is drawn as a dotted line, the graph corresponding to FIG. 12.
FIG. 14 is a graph illustrating a depth direction distribution of donor increments obtained in Example 3.
FIG. 15 is a graph illustrating a depth direction distribution of hydrogen concentrations obtained in Example 4.
FIG. 16 is a graph illustrating a depth direction distribution of donor increments obtained in Example 4.
FIG. 17 is a graph illustrating a relation between the hydrogen concentrations and the donor increments obtained in Example 4.

FIG. 18 is a graph illustrating a depth direction distribution of donor increments obtained in Example 4.

FIG. 19 is a graph illustrating a relation between donor increments and proton doses obtained in Comparative Example 1.

FIG. 20 is a graph illustrating a relation between donor increments and proton doses obtained in Comparative Example 2.

## DESCRIPTION OF EMBODIMENTS

Hereinafter, the present invention will be described in detail. However, the present invention is not limited thereto.

As noted above, it has been believed generally that when the same proton acceleration voltage in proton irradiation and the same heating condition after the proton irradiation are employed, the concentration of donors formed by the proton irradiation and the heating has a monotonic relation with the proton dose in the proton irradiation. However, this is not always true in reality. There is such a problem that work and cost are required to find out the proton dose at which a target donor concentration is obtained.

Further, the concentration of donors formed by proton irradiation and heating varies depending on the concentration of light element impurities in a silicon single crystal substrate. Hence, there is a problem that even if the same proton irradiation condition and the same heating condition are employed, the donor concentrations vary among silicon single crystal substrates.

The present inventor has earnestly studied the above problems and found the following. Specifically, in regard to a test silicon single crystal substrate, a depth direction distribution of hydrogen concentrations after proton irradiation is correlated with a depth direction distribution of donor increments after the proton irradiation and a heat treatment; based on this correlation between the hydrogen concentrations and the donor increments thus acquired, a hydrogen concentration corresponding to a target donor increment of a silicon single crystal substrate whose donor concentration is to be controlled is determined; and the silicon single crystal substrate whose donor concentration is to be controlled is irradiated with protons at a proton dose that is determined from this hydrogen concentration. Thereby, the target donor increment is achieved with high precision by the proton irradiation and the heat treatment. This finding has led to the completion of the present invention.

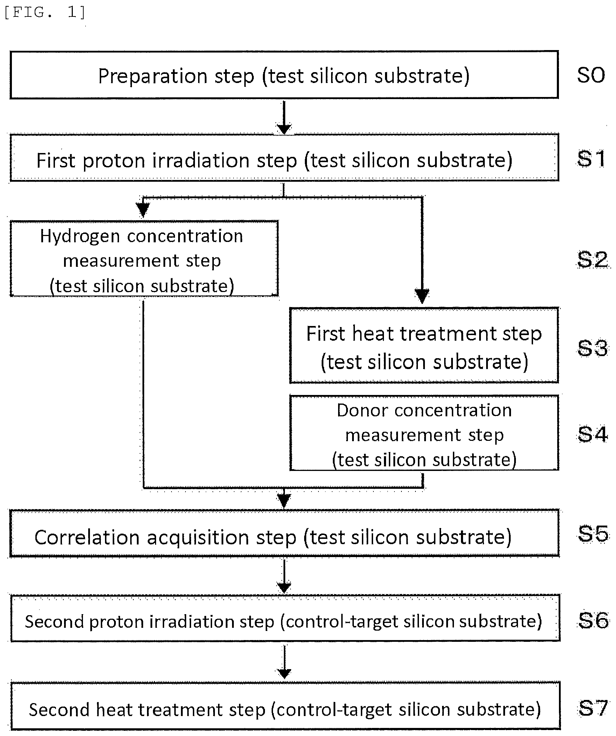

Hereinbelow, an example of the inventive method for controlling a donor concentration in a silicon single crystal substrate will be described with reference to FIG. 1. Note that silicon single crystal substrates in parentheses in FIG. 1 indicate silicon single crystal substrates treated in the respective steps.

[Preparation Step S0]

First, a test silicon single crystal substrate is prepared. The test silicon single crystal substrate prepared here is preferably prepared from a crystal block from which a silicon single crystal substrate whose donor concentration is to be actually controlled (hereinafter also referred to as control-target silicon single crystal substrate) is also obtained, or prepared from a crystal block produced according to the same specification as that for the control-target silicon single crystal substrate.

The method of preparing this test silicon single crystal substrate is not particularly limited in the present invention. For example, the test silicon single crystal substrate can be prepared by: slicing off silicon wafers from a silicon single crystal grown by a Czochralski method or a floating zone method; performing a chemical etching treatment on the silicon wafers to eliminate the slicing damage; and then performing chemical-mechanical polishing.

[First Proton Irradiation Step S1]

Next, a first proton irradiation step is performed to irradiate the test silicon single crystal substrate with protons (S1 in FIG. 1). In this event, before the proton irradiation, an oxide film or the like may be formed on the silicon single crystal substrate.

In the first proton irradiation step, the proton acceleration voltage is the same as the acceleration voltage employed in a proton irradiation step in a manufacturing process of a target semiconductor device, that is, a second proton irradiation step (S6 in FIG. 1) of irradiating with protons a silicon single crystal substrate whose donor concentration is to be controlled which will be described later in detail. Additionally, an absorber or the like may be used to adjust the range of protons. In this case, the material and thickness of the absorber are also the same as conditions in the second proton irradiation step. The acceleration voltage can be, for example, 8 MV.

In this event of the first proton irradiation step, a first proton dose $D1$ is preferably $1 \times 10^{14}$ atoms/cm$^2$ or more. Thereby, the depth direction distribution of hydrogen concentrations after the first proton irradiation step can be measured highly precisely, for example, by secondary ion mass spectrometry (SIMS). Meanwhile, the upper limit of the proton dose is not particularly limited. Nevertheless, since higher dose increases the cost of the proton irradiation, $1 \times 10^{16}$

atoms/cm$^2$ or less is more preferable.

Moreover, the silicon single crystal substrate may be divided into two or more parts after the first proton irradiation. A hydrogen concentration measurement step, a first heat treatment step, and a donor concentration measurement step to be described below are not particularly limited, as long as the silicon single crystal substrate is treated after the first proton irradiation. Nevertheless, when the substrate is divided into two or more parts, the hydrogen concentration measurement step, the first heat treatment step, and the donor concentration measurement step can be simultaneously performed on each of the divided substrates, which are originated from the same substrate. Thereby, measurement precision and efficiency are improved, and the cost reduction is also achieved.

[Hydrogen Concentration Measurement Step S2]

Next, the hydrogen concentration measurement step (S2 in FIG. 1) is performed to measure a depth direction distribution of hydrogen concentrations in the silicon single crystal substrate after the first proton irradiation step. The depth direction distribution of hydrogen concentrations can be measured, for example, by SIMS.

Next, data on the depth direction distribution of hydrogen concentrations measured in the hydrogen concentration measurement step are fitted to, for example, a Gaussian function of the following formula (1) to obtain a coefficient $N_0$, a median $\mu$, and a standard deviation $\sigma$. Here, $N_H(x)$ represents a hydrogen concentration at a depth x, and $N_H(\mu)$ represents a maximum hydrogen concentration in the depth direction distribution of hydrogen concentrations.

$$N_H(x) = N_0 \frac{1}{\sqrt{2\pi\sigma^2}} \exp\left(-\frac{(x-\mu)^2}{2\sigma^2}\right) \qquad (1)$$

Next, a coefficient A can be obtained according to the following formula (2) by using the proton dose D1 in the first proton irradiation step and the maximum hydrogen concentration $N_H(\mu)$ calculated according to the formula (1).

$$A = \frac{D1}{N_H(\mu)} \qquad (2)$$

[First Heat Treatment Step S3]

Next, the first heat treatment step (S3 in FIG. 1) is performed to heat the silicon single crystal substrate after the first proton irradiation step.

The heating conditions employed in the first heat treatment step are the same as the heating conditions employed in a heating step in the manufacturing process of a target semiconductor device, that is, a second heat treatment step (S7 in FIG. 1) on a silicon single crystal substrate whose donor concentration is to be controlled which will be described later in detail.

[Donor Concentration Measurement Step S4]

Next, the donor concentration measurement step (S4 in FIG. 1) is performed to measure a depth direction distribution of donor concentrations in the silicon single crystal substrate after the first heat treatment step. The depth direction distribution of donor concentrations can be measured, for example, by spreading resistance measurement method (SR method).

Next, a donor concentration in a matrix (a deep region where the donor concentration is substantially uniform) is subtracted from donor concentrations $N_D(x)$ at depths x measured in the donor concentration measurement step. Thereby, donor increments $\Delta N_D(x)$ at the depths x are obtained.

Next, the hydrogen concentrations $N_H(x)$ at the depths x where the donor increments are obtained can be calculated by the formula (1).

[Correlation Acquisition Step S5]

Next, the hydrogen concentrations $N_H(x)$ and the donor increments $\Delta N_D(x)$ at the depths x obtained in the hydrogen concentration measurement step (S2) and the donor concentration measurement step (S4) are associated with each other to thus perform a correlation acquisition step of acquiring a correlation between the hydrogen concentrations and the donor increments (S5 in FIG. 1).

In this event, preferably, a hydrogen concentration $N_H'$ at which the donor increment in the silicon single crystal substrate after a second heat treatment step reaches a target value is obtained based on the correlation acquired as described above, and a proton dose D2 ($=A\times N_H'$) is further determined by utilizing: the obtained hydrogen concentration $N_H'$; and the coefficient A obtained by the formula (2). In this manner, the proton dose in the second proton irradiation step can be determined more accurately, and the donor increment in the silicon single crystal substrate after the second heat treatment step can approach the target value with higher precision.

[Second Proton Irradiation Step S6]

Next, a prepared control-target silicon single crystal substrate is subjected to the second proton irradiation step at such a proton dose D2 as obtained above (S6 in FIG. 1).

In the second proton irradiation step, the proton acceleration voltage is the same acceleration voltage employed in the first proton irradiation step.

In this event, the dose of protons radiated in the second proton irradiation step is preferably adjusted for each crystal block. In this way, the donor concentration is controlled for each crystal block from which the control-target silicon single crystal substrate is also obtained, or for each crystal block produced according to the same specification as the control-target silicon single crystal substrate. Thus, variation in donor concentration due to, for example, blocks of silicon single crystal substrates can be further reduced.

[Second Heat Treatment Step S7]

Next, the proton-irradiated control-target silicon single crystal substrate is subjected to the second heat treatment step (S7 in FIG. 1). The heating conditions employed in the second heat treatment step are the same conditions as in the first heat treatment step. For example, the heating conditions can be: a heating temperature of 300 to 500°C, a treatment time of 20 minutes to 3 hours, and an atmosphere of nitrogen, oxygen, hydrogen, or the like.

According to the inventive method for controlling a donor concentration in a silicon single crystal substrate as described above, a correlation between hydrogen concentrations after a proton irradiation and donor increments in a test silicon single crystal substrate after the proton irradiation and a heat treatment is obtained in advance from the silicon single crystal substrate; this correlation is utilized to adjust a proton dose in a proton irradiation on a silicon single crystal substrate whose donor concentration is to be controlled (control-target silicon single crystal substrate), so that the donor concentration can be controlled. Thereby, a target donor concentration is achieved regardless of oxygen and carbon concentrations. In this case, the target value of the donor increment can be the maximum value in the depth direction distribution. It is also possible to easily determine a proton dose to successfully reduce variation in donor concentration due to silicon single crystal substrates.

EXAMPLE

Hereinafter, the present invention will be described in detail with reference to Examples. However, the present invention is not limited thereto.

(Example 1)

The target value of a donor increment attained by proton irradiation and heating was set at approximately $1\times10^{14}/cm^3$. The donor concentration in a silicon single crystal substrate was controlled by the inventive method for controlling a donor concentration as shown in FIG. 1.

First, a test silicon single crystal substrate was prepared from the same crystal block as a silicon single crystal substrate whose donor concentration was to be control (control-target silicon single crystal substrate) was also prepared (S0 in FIG. 1). This crystal block had been grown by the Czochralski (CZ) method. The dopant type, dopant concentration, oxygen concentration, carbon concentration, diameter, and crystal plane orientation of the silicon single crystal substrates were as follows.

dopant type/concentration: phosphorus/$7.7\times10^{13}$ atoms/$cm^3$,

oxygen concentration: 3.8 ppma,
carbon concentration: 0.04 ppma,
diameter: 200 mm,
crystal plane orientation: (100).

The oxygen concentration was measured by an infrared absorption method (using the conversion factor specified by JEIDA). The carbon concentration was measured by secondary ion mass spectrometry (SIMS). Table 1 shows the donor-increment target value, method of manufacturing the silicon single crystal, dopant type, dopant concentration, oxygen concentration, carbon concentration, diameter, and crystal plane orientation in Example 1.

[Table 1]

|  | Example 1 | Example 2 | Example 3 | Example 4 |
|---|---|---|---|---|
| Target donor-increment value [/cm$^3$] | about $1\times10^{14}$ | about $2\times10^{14}$ | about $3\times10^{14}$ | as high as possible |
| Silicon single crystal manufacturing method | CZ | CZ | FZ | CZ |
| Dopant type | phosphorus | Phosphorus | phosphorus | phosphorus |
| Dopant concentration [atoms/cm$^3$] | $7.7\times10^{13}$ | $9.4\times10^{13}$ | $6.9\times10^{13}$ | $1.3\times10^{14}$ |
| Oxygen concentration [ppma] | 3.8 | 3.3 | 0.04 | 10.3 |
| Carbon concentration [ppma] | 0.04 | 0.05 | 0.02 | 0.06 |
| Diameter [mm] of silicon single crystal | 200 | 200 | 200 | 200 |
| Crystal orientation | (100) | (100) | (100) | (100) |

Next, the first proton irradiation step was performed to irradiate the test silicon single crystal substrate with protons (S1 in FIG. 1). In this event, the proton dose was $2\times10^{14}$ atoms/cm$^2$, and the acceleration voltage was 8 MV. Moreover, in order to achieve the proton range of approximately 15 $\mu$m, multiple aluminum foils were placed as an absorber during the proton irradiation on the upstream side of the silicon single crystal substrate such that the foils had a total thickness of approximately 410 $\mu$m.

Next, the silicon single crystal substrate was divided into two after the first proton irradiation step, and one of these was subjected to the hydrogen concentration measurement step of measuring a depth direction distribution of hydrogen concentrations (S2 in FIG. 1). The depth direction distribution of hydrogen concentrations was measured by SIMS.

Next, data on the depth direction distribution of hydrogen concentrations measured in the hydrogen concentration measurement step were subjected to fitting with the formula (1) to obtain the coefficient $N_0$, median $\mu$, and standard deviation $\sigma$. As a result, $N_0$ was $1.8\times10^{18}$ atoms/cm$^3$, $\mu$ was 15.2 $\mu$m, and $\sigma$ was 8.9 $\mu$m.

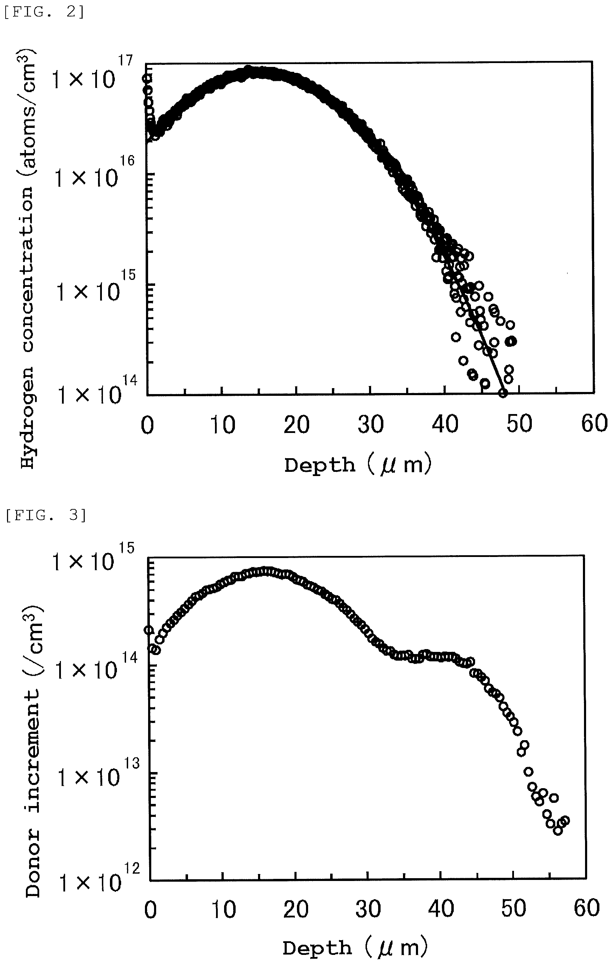

FIG. 2 shows the depth direction distribution of hydrogen concentrations in the silicon single crystal substrate after the first proton irradiation step. The marks in FIG. 2 represent the measurement results by SIMS, and each result represents a value obtained by subtracting the background (average value of hydrogen concentrations at depths from approximately 48 to 50 $\mu$m) from the hydrogen concentration at a depth x. Moreover, the solid line in FIG. 2 indicates the calculation result according to the formula 1.

Next, the proton dose D1 in the first proton irradiation step and the maximum hydrogen concentration $N_H(\mu)$ calculated by the formula (1) were used to determine the coefficient A by the formula (2). As a result, "A" was determined to be approximately $2.4\times10^{-3}$ cm.

Next, the remaining one of the silicon single crystal substrate was divided into two after the first proton irradiation step was heated to perform the first heat treatment step (S3 in FIG. 1). In this event, the heating temperature was 400°C, the time was 60 minutes, and the atmosphere was nitrogen atmosphere. Table 2 shows the proton dose D1 in the first proton irradiation step, acceleration voltage, proton range, absorber material, total absorber thickness, heating temperature, heating time, and atmosphere in Example 1.

[Table 2]

|  | Example 1 | Example 2 | Example 3 | Example 4 |
|---|---|---|---|---|
| Proton dose D1 [atoms/cm$^2$] in first proton irradiation step | $2\times10^{14}$ | $1\times10^{14}$ | $2\times10^{14}$ | $2\times10^{14}$ |
| Acceleration voltage [MV] | 8 | 8 | 8 | 8 |

(continued)

|  | Example 1 | Example 2 | Example 3 | Example 4 |
|---|---|---|---|---|
| Proton range [$\mu$m] | about 15 | about 15 | about 15 | about 15 |
| Absorber material | multiple aluminum foils | multiple aluminum foils | multiple aluminum foils | multiple aluminum foils |
| Total absorber thickness [$\mu$m] | about 410 | about 410 | about 410 | about 410 |
| Heating temperature [°C] | 400 | 350 | 350 | 350 |
| Heating time [min.] | 60 | 60 | 60 | 60 |
| Atmosphere | Nitrogen | nitrogen | Nitrogen | nitrogen |

Next, the silicon single crystal substrate after the first heat treatment step was subjected to the donor concentration measurement step of measuring a depth direction distribution of donor concentrations (S4 in FIG. 1). The depth direction distribution of donor concentrations was measured by spreading resistance measurement method (SR method).

Next, a donor concentration (average value of donor concentrations at depths from approximately 60 to 70 um) in a matrix (deep region where the donor concentration was substantially uniform) was subtracted from the donor concentrations $N_D(x)$ at depths x measured in the donor concentration measurement step. Thereby, donor increments $\Delta N_D(x)$ at the depths x were obtained. FIG. 3 shows the depth direction distribution of donor increments obtained in this manner.

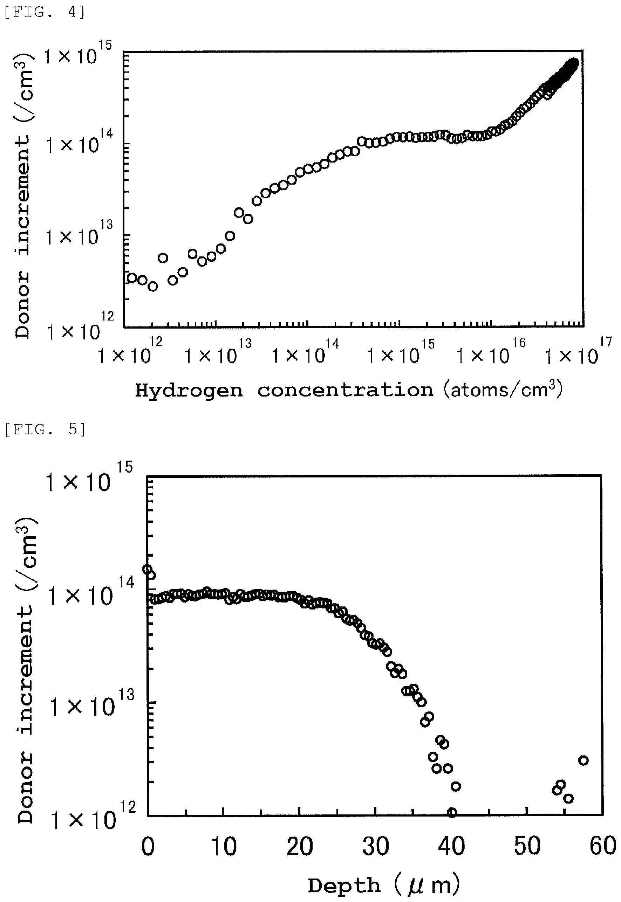

Next, hydrogen concentrations $N_H(x)$ at the depths x where the donor increments were obtained were calculated according to the formula (1). These $N_H(x)$ were associated with the donor increments $\Delta N_D(x)$. Thus, the correlation acquisition step of acquiring a correlation between the hydrogen concentrations and the donor increments was performed (S5 in FIG. 1). FIG. 4 shows the relation between the hydrogen concentrations and the donor increments thus acquired.

Next, based on the correlation (FIG. 4) acquired in the correlation acquisition step, the hydrogen concentration $N_H'$ was obtained at which the donor increment in the silicon single crystal substrate after the second heat treatment step would reach the target value (approximately $1 \times 10^{14}$/cm$^3$). As a result, $N_H'$ ranged from $4 \times 10^{14}$ to $1 \times 10^{16}$ atoms/cm$^3$.

Further, the range ($4 \times 10^{14}$ to $1 \times 10^{16}$ atoms/cm$^3$) of the obtained hydrogen concentration $N_H'$ and the above-obtained coefficient A ($2.4 \times 10^{-3}$ cm) of the formula (2) were used to determine that the proton dose D2 (=$A \times N_H'$) of the second proton irradiation step ranged from $9.6 \times 10^{11}$ to $2.4 \times 10^{13}$ atoms/cm$^2$.

Next, the prepared control-target silicon single crystal substrate was subjected to the second proton irradiation step such that the proton dose was within the above-determined range of D2 (S6 in FIG. 1). In this event, the proton dose was $3 \times 10^{12}$ atoms/cm$^2$, and the acceleration voltage was 8 MV. Table 3 shows the coefficient $N_0$, median $\mu$, standard deviation $\sigma$, coefficient A, hydrogen concentration $N_H'$, and proton dose in the second proton irradiation step employed in Example 1.

[Table 3]

|  | Example 1 | Example 2 | Example 3 | Example 4 |
|---|---|---|---|---|
| Coefficient $N_0$ [atoms/cm$^3$] | $1.8 \times 10^{18}$ | $9.64 \times 10^{17}$ | $1.79 \times 10^{18}$ | $1.84 \times 10^{18}$ |
| Median $\mu$ [$\mu$m] | 15.2 | 14.7 | 15.4 | 15.3 |
| Standard deviation $\sigma$ [$\mu$m] | 8.9 | 8.9 | 8.8 | 9.0 |
| Coefficient A [cm] | about $2.4 \times 10^{-3}$ | about $2.5 \times 10^{-3}$ | about $2.5 \times 10^{-3}$ | about $2.4 \times 10^{-3}$ |
| Hydrogen concentration $N_H'$ [atoms/cm$^3$] | $4 \times 10^{14}$ to $1 \times 10^{16}$ | $4 \times 10^{15}$ to $6 \times 10^{15}$ | $3 \times 10^{16}$ to $4 \times 10^{16}$ | $4 \times 10^{15}$ to $1 \times 10^{16}$ |
| Range of proton dose D2 [atoms/cm$^2$] in second proton irradiation step | $9.6 \times 10^{11}$ to $2.4 \times 10^{13}$ | $1.0 \times 10^{13}$ to $1.5 \times 10^{13}$ | $7.5 \times 10^{13}$ to $1.0 \times 10^{14}$ | $9.6 \times 10^{12}$ to $2.4 \times 10^{13}$ |
| Proton dose [atoms/cm$^2$] in second proton irradiation step | $3 \times 10^{12}$ | $1 \times 10^{13}$ | $1 \times 10^{14}$ | $2 \times 10^{13}$ |

Next, the control-target silicon single crystal substrate irradiated with protons was subjected to the second heat treatment step (S7 in FIG. 1). In this event, the heating temperature was 400°C, the time was 60 minutes, and the atmosphere was nitrogen atmosphere.

Next, the depth direction distribution of donor concentrations in the silicon single crystal substrate after the second heat treatment step was measured by SR method.

Next, a donor concentration (average value of donor concentrations at depths from approximately 60 to 70 um) in a matrix (deep region where the donor concentration was substantially uniform) was subtracted from donor concentrations $N_D(x)$ at the depths x measured in the donor concentration measurement step. Thereby, donor increments $\Delta N_D(x)$ at the depths x were obtained.

FIG. 5 shows the depth direction distribution of donor increments obtained as above. This result showed that the donor increment was the target value of approximately $1\times10^{14}$/cm$^3$. Thus, it was confirmed in Example 1 that the donor increment of the target value was obtained by the inventive method for controlling a donor concentration in a silicon single crystal substrate.

(Example 2)

The target value of a donor increment attained by proton irradiation and heating was set at approximately $2\times10^{14}$/cm$^3$. The donor concentration in a silicon single crystal substrate was controlled by the inventive method for controlling a donor concentration as shown in FIG. 1.

First, a test silicon single crystal substrate was prepared from the same crystal block as a silicon single crystal substrate whose donor concentration was to be control (control-target silicon single crystal substrate) (S0 in FIG. 1). This crystal block had been grown by the Czochralski (CZ) method. The dopant type, dopant concentration, oxygen concentration, carbon concentration, diameter, and crystal plane orientation of the silicon single crystal substrates were as follows.

dopant type/concentration: phosphorus/$9.4\times10^{13}$ atoms/cm$^3$,
oxygen concentration: 3.3 ppma,
carbon concentration: 0.05 ppma,
diameter: 200 mm,
crystal plane orientation: (100).

The oxygen concentration was measured by an infrared absorption method (using the conversion factor specified by JEIDA). The carbon concentration was measured by secondary ion mass spectrometry (SIMS). Table 1 also shows the donor-increment target value, method of manufacturing the silicon single crystal, dopant type, dopant concentration, oxygen concentration, carbon concentration, diameter, and crystal plane orientation in Example 2.

Next, the first proton irradiation step was performed to irradiate the test silicon single crystal substrate with protons (S1 in FIG. 1). In this event, the proton dose was $1\times10^{14}$ atoms/cm$^2$, and the acceleration voltage was 8 MV. Moreover, in order to achieve the proton range of approximately 15 um, multiple aluminum foils were placed as an absorber during the proton irradiation on the upstream side of the silicon single crystal substrate such that the foils had a total thickness of approximately 410 $\mu$m.

Next, the silicon single crystal substrate was divided into two after the first proton irradiation step, and one of these was subjected to the hydrogen concentration measurement step of measuring a depth direction distribution of hydrogen concentrations (S2 in FIG. 1). The depth direction distribution of hydrogen concentrations was measured by SIMS.

Next, data on the depth direction distribution of hydrogen concentrations measured in the hydrogen concentration measurement step were subjected to fitting with the formula (1) to obtain the coefficient $N_0$, median $\mu$, and standard deviation $\sigma$. As a result, $N_0$ was $9.64\times10^{17}$ atoms/cm$^3$, $\mu$ was 14.7 um, and $\sigma$ was 8.9 $\mu$m.

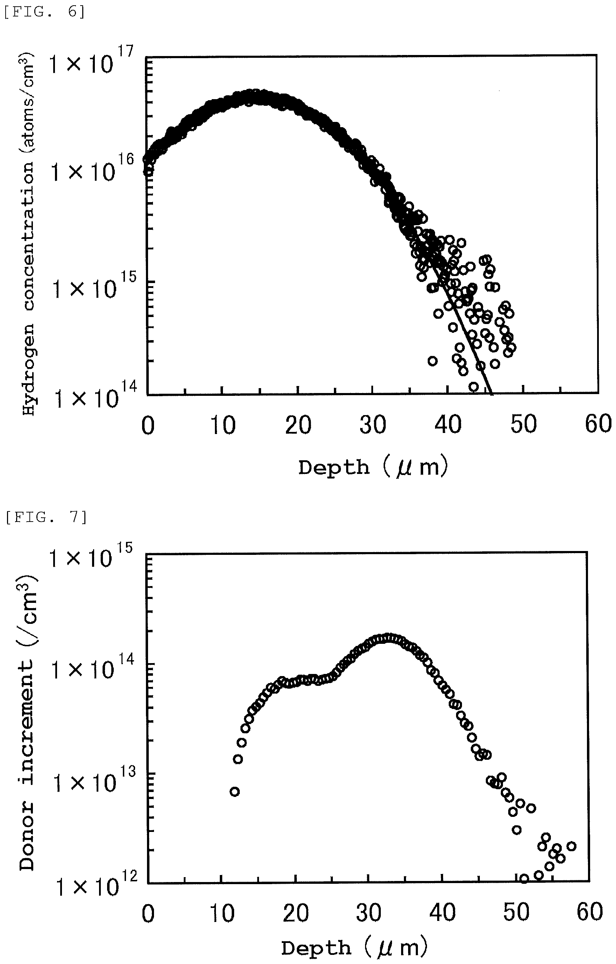

FIG. 6 shows the depth direction distribution of hydrogen concentrations in the silicon single crystal substrate after the first proton irradiation step. The marks in FIG. 6 represent the measurement results by SIMS, and each result represents a value obtained by subtracting the background (average value of hydrogen concentrations at depths from approximately 48 to 50 $\mu$m) from the hydrogen concentration at a depth x. Moreover, the solid line in FIG. 6 indicates the calculation result according to the formula 1.

Next, the proton dose D1 in the first proton irradiation step and the maximum hydrogen concentration $N_H(\mu)$ calculated by the formula (1) were used to determine the coefficient A by the formula (2). As a result, "A" was determined to be approximately $2.5\times10^{-3}$ cm.

Next, the remaining one of the silicon single crystal substrate was divided into two after the first proton irradiation step was heated to perform the first heat treatment step (S3 in FIG. 1). In this event, the heating temperature was 350°C, the time was 60 minutes, and the atmosphere was nitrogen atmosphere. Table 2 also shows the proton dose D1 in the first proton irradiation step, acceleration voltage, proton range, absorber material, total absorber thickness, heating temperature, heating time, and atmosphere in Example 2.

Next, the silicon single crystal substrate after the first heat treatment step was subjected to the donor concentration measurement step of measuring a depth direction distribution of donor concentrations (S4 in FIG. 1). The depth direction distribution of donor concentrations was measured by spreading resistance measurement method (SR method).

Next, a donor concentration (average value of donor concentrations at depths from approximately 60 to 70 um) in a matrix (deep region where the donor concentration was substantially uniform) was subtracted from the donor concentrations $N_D(x)$ at depths x measured in the donor concentration measurement step. Thereby, donor increments $\Delta N_D(x)$ at the depths x were obtained. FIG. 7 shows the depth direction distribution of donor increments obtained in this manner.

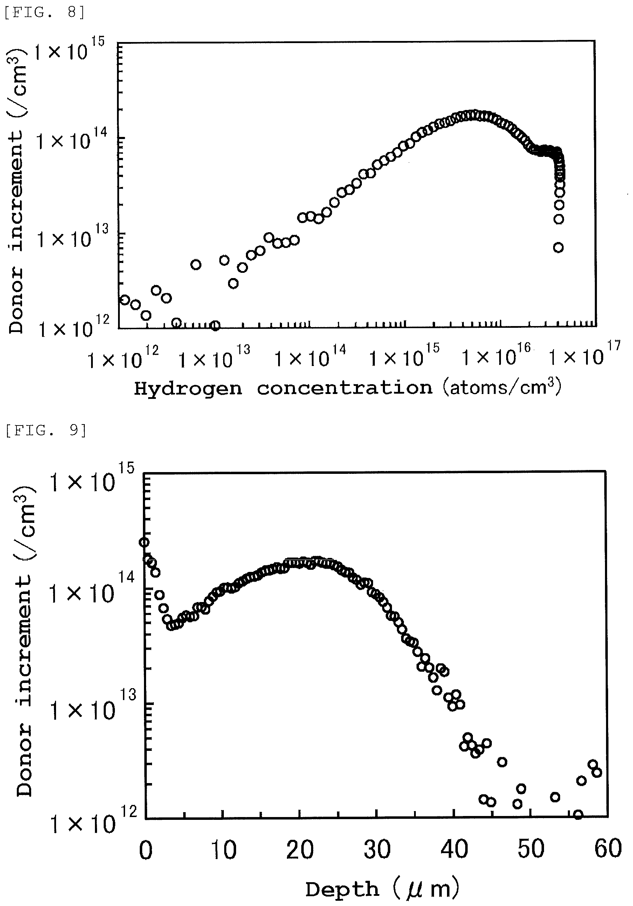

Next, hydrogen concentrations $N_H(x)$ at the depths x where the donor increments were obtained were calculated according to the formula (1). These $N_H(x)$ were associated with the donor increments $\Delta N_D(x)$. Thus, the correlation acquisition step of acquiring a correlation between the hydrogen concentrations and the donor increments was performed (S5 in FIG. 1). FIG. 8 shows the relation between the hydrogen concentrations and the donor increments thus acquired.

Next, based on the correlation (FIG. 8) acquired in the correlation acquisition step, the hydrogen concentration $N_H'$ was obtained at which the donor increment in the silicon single crystal substrate after the second heat treatment step would reach the target value (approximately $2 \times 10^{14}/cm^3$). As a result, $N_H'$ ranged from $4 \times 10^{15}$ to $6 \times 10^{15}$ atoms/cm$^3$.

Further, the range ($4 \times 10^{15}$ to $6 \times 10^{15}$ atoms/cm$^3$) of the obtained hydrogen concentration $N_H'$ and the above-obtained coefficient A ($2.5 \times 10^{-3}$ cm) of the formula (2) were used to determine that the proton dose D2 ($=A \times N_H'$) of the second proton irradiation step ranged from $1.0 \times 10^{13}$ to $1.5 \times 10^{13}$ atoms/cm$^2$.

Next, the prepared control-target silicon single crystal substrate was subjected to the second proton irradiation step such that the proton dose was D2 determined above (S6 in FIG. 1). In this event, the proton dose was $1 \times 10^{13}$ atoms/cm$^2$, and the acceleration voltage was 8 MV. Table 3 also shows the coefficient $N_0$, median $\mu$, standard deviation $\sigma$, coefficient A, hydrogen concentration $N_H'$, and proton dose in the second proton irradiation step employed in Example 2.

Next, the control-target silicon single crystal substrate irradiated with protons was subjected to the second heat treatment step (S7 in FIG. 1). In this event, the heating temperature was 350°C, the time was 60 minutes, and the atmosphere was nitrogen atmosphere.

Next, the depth direction distribution of donor concentrations in the silicon single crystal substrate after the second heat treatment step was measured by SR method.

Next, a donor concentration (average value of donor concentrations at depths from approximately 60 to 70 $\mu$m) in a matrix (deep region where the donor concentration was substantially uniform) was subtracted from donor concentrations $N_D(x)$ at the depths x measured in the donor concentration measurement step. Thereby, donor increments $\Delta N_D(x)$ at the depths x were obtained.

FIG. 9 shows the depth direction distribution of donor increments obtained as above. This result showed that the donor increment was the target value of approximately $2 \times 10^{14}/cm^3$.

Thus, it was confirmed in Example 2 that the donor increment of the target value was obtained by the inventive method for controlling a donor concentration in a silicon single crystal substrate.

(Example 3)

The target value of a donor increment attained by proton irradiation and heating was set at approximately $3 \times 10^{14}/cm^3$. The donor concentration in a silicon single crystal substrate was controlled by the inventive method for controlling a donor concentration as shown in FIG. 1.

First, a test silicon single crystal substrate was prepared from the same crystal block as a silicon single crystal substrate whose donor concentration was to be control (control-target silicon single crystal substrate) (S0 in FIG. 1). This crystal block had been grown by the floating zone (FZ) method. The dopant type, dopant concentration, oxygen concentration, carbon concentration, diameter, and crystal plane orientation of the silicon single crystal substrates were as follows.

dopant type/concentration: phosphorus/$6.9 \times 10^{13}$ atoms/cm$^3$,
oxygen concentration: 0.04 ppma,
carbon concentration: 0.02 ppma,
diameter: 200 mm,
crystal plane orientation: (100).

The oxygen concentration and the carbon concentration were measured by secondary ion mass spectrometry (SIMS). Table 1 also shows the donor-increment target value, method of manufacturing the silicon single crystal, dopant type, dopant concentration, oxygen concentration, carbon concentration, diameter, and crystal plane orientation in Example 3.

Next, the first proton irradiation step was performed to irradiate the test silicon single crystal substrate with protons (S1 in FIG. 1). In this event, the proton dose was $2\times10^{14}$ atoms/cm$^2$, and the acceleration voltage was 8 MV. Moreover, in order to achieve the proton range of approximately 15 $\mu$m, multiple aluminum foils were placed as an absorber during the proton irradiation on the upstream side of the silicon single crystal substrate such that the foils had a total thickness of approximately 410 $\mu$m.

Next, the silicon single crystal substrate was divided into two after the first proton irradiation step, and one of these was subjected to the hydrogen concentration measurement step of measuring a depth direction distribution of hydrogen concentrations (S2 in FIG. 1). The depth direction distribution of hydrogen concentrations was measured by SIMS.

Next, data on the depth direction distribution of hydrogen concentrations measured in the hydrogen concentration measurement step were subjected to fitting with the formula (1) to obtain the coefficient $N_0$, median $\mu$, and standard deviation $\sigma$. As a result, $N_0$ was $1.79\times10^{18}$ atoms/cm$^3$, $\mu$ was 15.4 $\mu$m, and $\sigma$ was 8.8 $\mu$m.

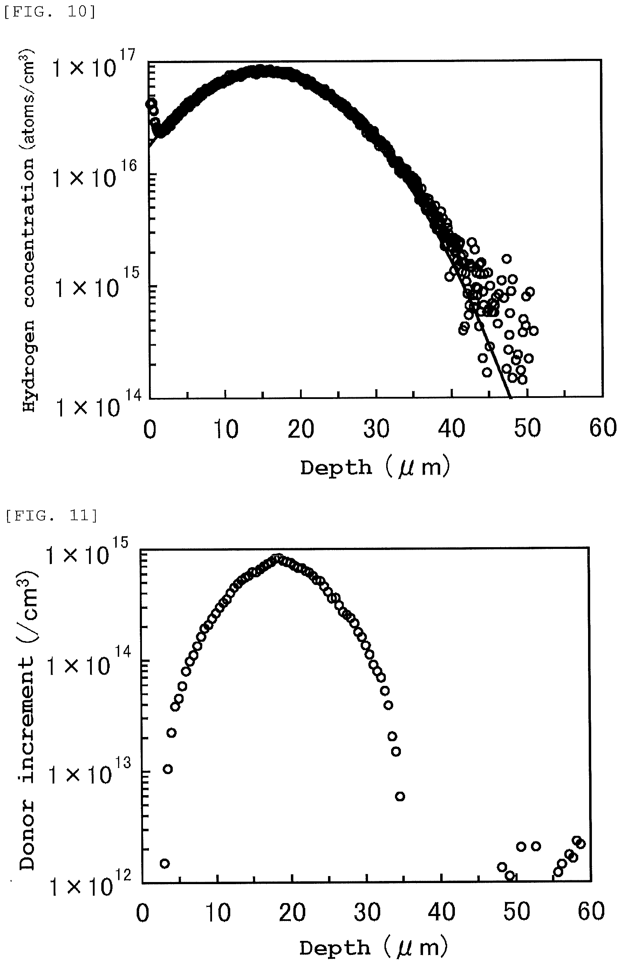

FIG. 10 shows the depth direction distribution of hydrogen concentrations in the silicon single crystal substrate after the first proton irradiation step. The marks in FIG. 10 represent the measurement results by SIMS, and each result represents a value obtained by subtracting the background (average value of hydrogen concentrations at depths from approximately 48 to 50 $\mu$m) from the hydrogen concentration at a depth x. Moreover, the solid line in FIG. 10 indicates the calculation result according to the formula 1.

Next, the proton dose D1 in the first proton irradiation step and the maximum hydrogen concentration $N_H(\mu)$ calculated by the formula (1) were used to determine the coefficient A by the formula (2). As a result, "A" was determined to be approximately $2.5\times10^{-3}$ cm.

Next, the remaining one of the silicon single crystal substrate was divided into two after the first proton irradiation step was heated to perform the first heat treatment step (S3 in FIG. 1). In this event, the heating temperature was 350°C, the time was 60 minutes, and the atmosphere was nitrogen atmosphere. Table 2 also shows the proton dose D1 in the first proton irradiation step, acceleration voltage, proton range, absorber material, total absorber thickness, heating temperature, heating time, and atmosphere in Example 3.

Next, the silicon single crystal substrate after the first heat treatment step was subjected to the donor concentration measurement step of measuring a depth direction distribution of donor concentrations (S4 in FIG. 1). The depth direction distribution of donor concentrations was measured by spreading resistance measurement method (SR method).

Next, a donor concentration (average value of donor concentrations at depths from approximately 60 to 70 um) in a matrix (deep region where the donor concentration was substantially uniform) was subtracted from the donor concentrations $N_D(x)$ at depths x measured in the donor concentration measurement step. Thereby, donor increments $\Delta N_D(x)$ at the depths x were obtained. FIG. 11 shows the depth direction distribution of donor increments obtained in this manner.

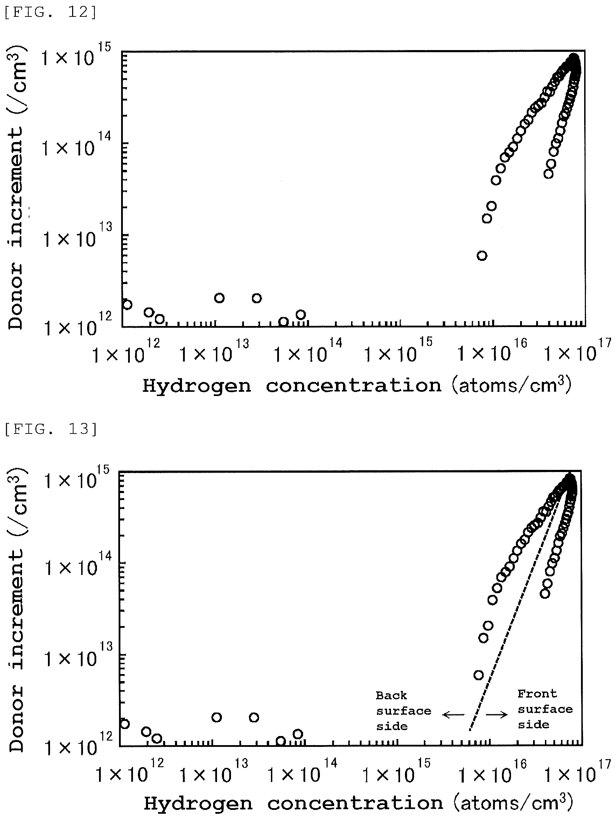

Next, hydrogen concentrations $N_H(x)$ at the depths x where the donor increments were obtained were calculated according to the formula (1). These $N_H(x)$ were associated with the donor increments $\Delta N_D(x)$. Thus, the correlation acquisition step of acquiring a correlation between the hydrogen concentrations and the donor increments was performed (S5 in FIG. 1). FIG. 12 shows the relation between the hydrogen concentrations and the donor increments thus acquired.

In FIG. 12, there are two correlations between the hydrogen concentrations and the donor increments. This is because the depth direction distribution of the donor increments is asymmetrical with respect to a depth $\mu$ where the hydrogen concentration is maximum. The depth direction distribution of the donor increments is asymmetrical because the irradiation damage by the proton irradiation reduced the carrier concentration more on the front surface side than on the back surface side in the vicinity of the proton range. FIG. 13 shows a graph in which a dotted line indicates the border line between the front surface side and the back surface side in the relations between the hydrogen concentrations and the donor increments shown in FIG. 12. In such a case, the hydrogen concentration for obtaining the target donor increment is determined based on the correlation on the back surface side in terms of the proton range.

Next, based on the correlation (FIG. 12) acquired in the correlation acquisition step, the hydrogen concentration $N_H'$ was obtained at which the donor increment in the silicon single crystal substrate after the second heat treatment step would reach the target value (approximately $3\times10^{14}$/cm$^3$). As a result, $N_H'$ ranged from $3\times10^{16}$ to $4\times10^{16}$ atoms/cm$^3$.

Further, the range ($3\times10^{16}$ to $4\times10^{16}$ atoms/cm$^3$) of the obtained hydrogen concentration $N_H'$ and the above-obtained coefficient A ($2.5\times10^{-3}$ cm) of the formula (2) were used to determine that the proton dose D2 ($=A\times N_H'$) of the second proton irradiation step ranged from $7.5\times10^{13}$ to $1.0\times10^{14}$ atoms/cm$^2$.

Next, the prepared control-target silicon single crystal substrate was subjected to the second proton irradiation step such that the proton dose was D2 determined above (S6 in FIG. 1). In this event, the proton dose was $1\times10^{14}$ atoms/cm$^2$, and the acceleration voltage was 8 MV. Table 3 also shows the coefficient $N_0$, median $\mu$, standard deviation $\sigma$, coefficient A, hydrogen concentration $N_H'$, and proton dose in the second proton irradiation step employed in Example 3.

Next, the control-target silicon single crystal substrate irradiated with protons was subjected to the second heat treatment step (S7 in FIG. 1). In this event, the heating temperature was 350°C, the time was 60 minutes, and the atmosphere was nitrogen atmosphere.

Next, the depth direction distribution of donor concentrations in the silicon single crystal substrate after the second heat treatment step was measured by SR method.

Next, a donor concentration (average value of donor concentrations at depths from approximately 60 to 70 $\mu$m) in a matrix (deep region where the donor concentration was substantially uniform) was subtracted from donor concentrations $N_D(x)$ at the depths x measured in the donor concentration measurement step. Thereby, donor increments $\Delta N_D(x)$ at the depths x were obtained.

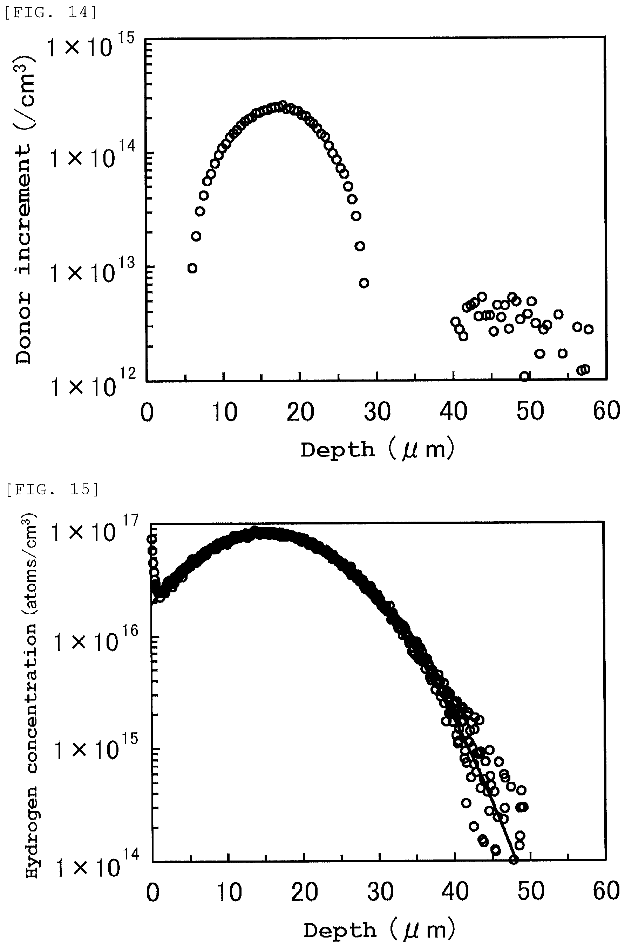

FIG. 14 shows the depth direction distribution of donor increments obtained as above. This result showed that the donor increment was the target value of approximately $3\times10^{14}$/cm$^3$.

Thus, it was confirmed in Example 3 that the donor increment of the target value was obtained by the inventive method for controlling a donor concentration in a silicon single crystal substrate.

(Example 4)

The donor concentration in a silicon single crystal substrate was controlled by the inventive method for controlling a donor concentration as shown in FIG. 1, without setting the target value of a donor increment attained by proton irradiation and heating but the donor increment was to be as high as possible.

First, a test silicon single crystal substrate was prepared from the same crystal block as a silicon single crystal substrate whose donor concentration was to be control (control-target silicon single crystal substrate) (S0 in FIG. 1). This crystal block had been grown by the Czochralski (CZ) method. The dopant type, dopant concentration, oxygen concentration, carbon concentration, diameter, and crystal plane orientation of the silicon single crystal substrates were as follows.

dopant type/concentration: phosphorus/$1.3\times10^{14}$ atoms/cm$^3$,
oxygen concentration: 10.3 ppma,
carbon concentration: 0.06 ppma,
diameter: 200 mm,
crystal plane orientation: (100).

The oxygen concentration was measured by an infrared absorption method (using the conversion factor specified by JEIDA). The carbon concentration was measured by secondary ion mass spectrometry (SIMS). Table 1 also shows the donor-increment target value, method of manufacturing the silicon single crystal, dopant type, dopant concentration, oxygen concentration, carbon concentration, diameter, and crystal plane orientation in Example 4.

Next, the first proton irradiation step was performed to irradiate the test silicon single crystal substrate with protons (S1 in FIG. 1). In this event, the proton dose was $2\times10^{14}$ atoms/cm$^2$, and the acceleration voltage was 8 MV. Moreover, in order to achieve the proton range of approximately 15 um, multiple aluminum foils were placed as an absorber during the proton irradiation on the upstream side of the silicon single crystal substrate such that the foils had a total thickness of approximately 410 $\mu$m.

Next, the silicon single crystal substrate was divided into two after the first proton irradiation step, and one of these was subjected to the hydrogen concentration measurement step of measuring a depth direction distribution of hydrogen concentrations (S2 in FIG. 1). The depth direction distribution of hydrogen concentrations was measured by SIMS.

Next, data on the depth direction distribution of hydrogen concentrations measured in the hydrogen concentration measurement step were subjected to fitting with the formula 1 to obtain the coefficient $N_0$, median $\mu$, and standard deviation $\sigma$. As a result, $N_0$ was $1.84\times10^{18}$ atoms/cm$^3$, $\mu$ was 15.3 um, and $\sigma$ was 9.0 $\mu$m.

FIG. 15 shows the depth direction distribution of hydrogen concentrations in the silicon single crystal substrate after the first proton irradiation step. The marks in FIG. 15 represent the measurement results by SIMS, and each result represents a value obtained by subtracting the background (average value of hydrogen concentrations at depths from approximately 48 to 50 $\mu$m) from the hydrogen concentration at a depth x. Moreover, the solid line in FIG. 15 indicates the calculation result according to the formula 1.

Next, the proton dose D1 in the first proton irradiation step and the maximum hydrogen concentration $N_H(\mu)$ calculated by the formula (1) were used to determine the coefficient A by the formula (2). As a result, "A" was determined to be approximately $2.4\times10^{-3}$ cm.

Next, the remaining one of the silicon single crystal substrate was divided into two after the first proton irradiation step was heated to perform the first heat treatment step (S3 in FIG. 1). In this event, the heating temperature was 350°C, the time was 60 minutes, and the atmosphere was nitrogen atmosphere. Table 2 also shows the proton dose D1 in the first proton irradiation step, acceleration voltage, proton range, absorber material, total absorber thickness, heating temperature, heating time, and atmosphere in Example 4.

Next, the silicon single crystal substrate after the first heat treatment step was subjected to the donor concentration measurement step of measuring a depth direction distribution of donor concentrations (S4 in FIG. 1). The depth direction distribution of donor concentrations was measured by spreading resistance measurement method (SR method).

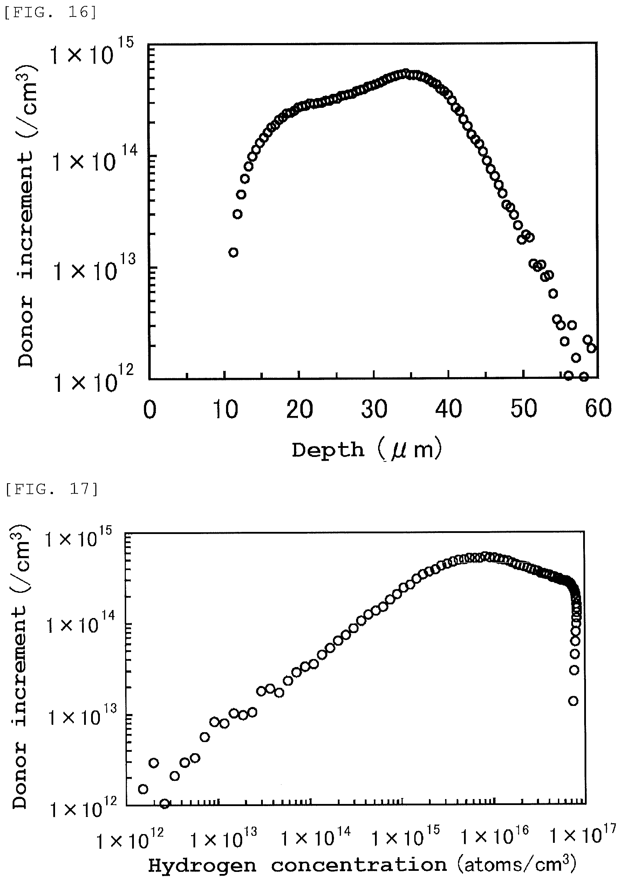

Next, a donor concentration (average value of donor concentrations at depths from approximately 60 to 70 um) in a matrix (deep region where the donor concentration was substantially uniform) was subtracted from the donor concentrations $N_D(x)$ at depths x measured in the donor concentration measurement step. Thereby, donor increments $\Delta N_D(x)$ at the depths x were obtained. FIG. 16 shows the depth direction distribution of donor increments obtained in this manner.

Next, hydrogen concentrations $N_H(x)$ at the depths x where the donor increments were obtained were calculated according to the formula (1). These $N_H(x)$ were associated with the donor increments $\Delta N_D(x)$. Thus, the correlation acquisition step of acquiring a correlation between the hydrogen concentrations and the donor increments was performed (S5 in FIG. 1).

FIG. 17 shows the relation between the hydrogen concentrations and the donor increments acquired in the correlation acquisition step. This result revealed that the highest donor increment was approximately $5 \times 10^{14}$/cm$^3$.

Next, based on the correlation (FIG. 17) acquired in the correlation acquisition step, the hydrogen concentration $N_H$' was obtained at which the donor increment in the silicon single crystal substrate after the second heat treatment step would reach approximately $5 \times 10^{14}$/cm$^3$. As a result, $N_H$' ranged from $4 \times 10^{15}$ to $1 \times 10^{16}$ atoms/cm$^3$.

Further, the range ($4 \times 10^{15}$ to $1 \times 10^{16}$ atoms/cm$^3$) of the obtained hydrogen concentration $N_H$' and the above-obtained coefficient A ($2.4 \times 10^{-3}$ cm) of the formula (2) were used to determine that the proton dose D2 (=A×$N_H$') of the second proton irradiation step ranged from $9.6 \times 10^{12}$ to $2.4 \times 10^{13}$ atoms/cm$^2$.

Next, the prepared control-target silicon single crystal substrate was subjected to the second proton irradiation step such that the proton dose was D2 determined above (S6 in FIG. 1). In this event, the proton dose was $2 \times 10^{13}$ atoms/cm$^2$, and the acceleration voltage was 8 MV. Table 3 also shows the coefficient $N_0$, median $\mu$, standard deviation $\sigma$, coefficient A, hydrogen concentration $N_H$', and proton dose in the second proton irradiation step employed in Example 4.

Next, the control-target silicon single crystal substrate irradiated with protons was subjected to the second heat treatment step (S7 in FIG. 1). In this event, the heating temperature was 350°C, the time was 60 minutes, and the atmosphere was nitrogen atmosphere.

Next, the depth direction distribution of donor concentrations in the silicon single crystal substrate after the second heat treatment step was measured by SR method.

Next, a donor concentration (average value of donor concentrations at depths from approximately 60 to 70 um) in a matrix (deep region where the donor concentration was substantially uniform) was subtracted from donor concentrations $N_D(x)$ at the depths x measured in the donor concentration measurement step. Thereby, donor increments $\Delta N_D(x)$ at the depths x were obtained.

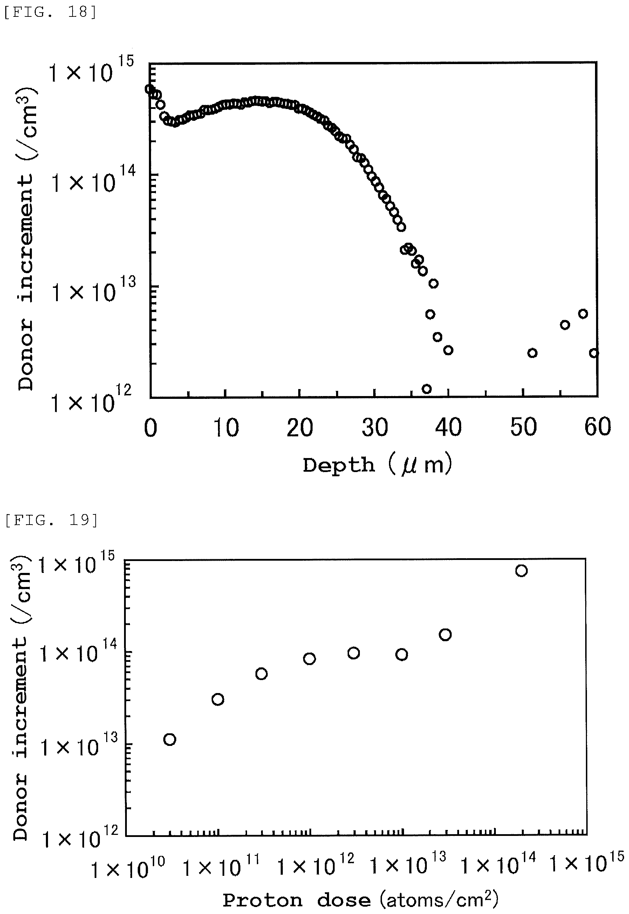

FIG. 18 shows the depth direction distribution of donor increments obtained as above. This result showed that the donor increment was the target value of approximately $5 \times 10^{14}$/cm$^3$.

Thus, it was confirmed in Example 4 that the inventive method for controlling a donor concentration in a silicon single crystal substrate can determine a condition to efficiently enable high donor increment.

From the foregoing, in Examples 1 to 4, it was possible to easily determine proton doses to obtain the target donor concentrations and to successfully reduce variation in donor concentration due to silicon single crystal substrates.

(Comparative Example 1)

The target value of a donor increment attained by proton irradiation and heating was set at approximately $1 \times 10^{14}$/cm$^3$. Nevertheless, the donor concentration in a silicon single crystal substrate was not controlled according to the inventive method for controlling a donor concentration, but was controlled as follows.

First, eight test silicon single crystal substrates were prepared from the same crystal block as a silicon single crystal substrate whose donor concentration was to be control (control-target silicon single crystal substrate). This crystal block was the same crystal block in Example 1 and had been grown by the Czochralski method. The dopant type, dopant concentration, oxygen concentration, carbon concentration, diameter, and crystal plane orientation of the silicon single crystal substrates were the same as those in Example 1.

Next, the eight test silicon single crystal substrates were irradiated with protons at different doses. In this event, the proton doses were set at $3 \times 10^{10}$, $1 \times 10^{11}$, $3 \times 10^{11}$, $1 \times 10^{12}$, $3 \times 10^{12}$, $1 \times 10^{13}$, $3 \times 10^{13}$, and $2 \times 10^{14}$ atoms/cm$^2$, and the acceleration voltage was 8 MV. Moreover, in order to achieve the proton range of approximately 15 $\mu$m, multiple aluminum foils were placed as an absorber during the proton irradiation on the upstream side of the silicon single crystal substrate such that the foils had a total thickness of approximately 410 um.

Next, the eight silicon single crystal substrates after the proton irradiation were heated. In this event, the heating temperature was 400°C, the time was 60 minutes, and the atmosphere was nitrogen atmosphere.

Next, the depth direction distribution of donor concentrations in each of the eight silicon single crystal substrates after the heating was measured by spreading resistance measurement method (SR method).

Next, a donor concentration (average value of donor concentrations at depths from approximately 60 to 70 um) in a matrix (deep region where the donor concentration was substantially uniform) was subtracted from the measured donor concentrations $N_D(x)$ at depths x. Thereby, donor increments $\Delta N_D(x)$ at the depths x were obtained. Further, a donor increment at a depth of the maximum donor increment attained was determined (maximum donor increment).

FIG. 19 shows a relation between the proton doses and each maximum donor increment determined as described above. From this result, the proton dose was obtained at which the donor increment would reach the target value (approximately $1\times10^{14}$/cm$^3$). As a result, the proton dose ranged from approximately $1\times10^{12}$ to $1\times10^{13}$ atoms/cm$^2$.

Next, the prepared control-target silicon single crystal substrate was irradiated with protons at a dose of $3\times10^{12}$ atoms/cm$^2$. The proton acceleration voltage was 8 MV.

Next, the control-target silicon single crystal substrate irradiated with protons was heated. In this event, the heating temperature was 400°C, the time was 60 minutes, and the atmosphere was nitrogen atmosphere.

Next, the depth direction distribution of donor concentrations in the heated silicon single crystal substrate was measured by SR method.

Next, a donor concentration (average value of donor concentrations at depths from approximately 60 to 70 um) in a matrix (deep region where the donor concentration was substantially uniform) was subtracted from donor concentrations $N_D(x)$ at the depths x measured in the donor concentration measurement step. Thereby, donor increments $\Delta N_D(x)$ at the depths x were obtained.

As a result of measuring the depth direction distribution of donor increments as described above, the obtained result was substantially the same as that in FIG. 5. This result showed that the donor increment was the target value of approximately $1\times10^{14}$/cm$^3$.

In this manner, although the target donor increment was obtained in Comparative Example 1, since the inventive method for controlling a donor concentration in a silicon single crystal substrate was not employed, the number of test silicon single crystal substrates was large, and the numbers of proton irradiations and donor concentration measurements were also large. Thus, more work and cost were required.

(Comparative Example 2)

The target value of a donor increment attained by proton irradiation and heating was set at approximately $3\times10^{14}$/cm$^3$. Nevertheless, the donor concentration in a silicon single crystal substrate was not controlled according to the inventive method for controlling a donor concentration, but was controlled as follows.

First, five test silicon single crystal substrates were prepared from the same crystal block as a silicon single crystal substrate whose donor concentration was to be control (control-target silicon single crystal substrate). This crystal block was the same crystal block in Example 3 and had been grown by the floating zone method. The dopant type, dopant concentration, oxygen concentration, carbon concentration, diameter, and crystal plane orientation of the silicon single crystal substrates were the same as those in Example 3.

Next, the five test silicon single crystal substrates were irradiated with protons at different doses. In this event, the proton doses were set at $3\times10^{12}$, $1\times10^{13}$, $3\times10^{13}$, $1\times10^{14}$, and $2\times10^{14}$ atoms/cm$^2$, and the acceleration voltage was 8 MV. Moreover, in order to achieve the proton range of approximately 15 $\mu$m, multiple aluminum foils were placed as an absorber during the proton irradiation on the upstream side of the silicon single crystal substrate such that the foils had a total thickness of approximately 410 $\mu$m.

Next, the five silicon single crystal substrates after the proton irradiation were heated. In this event, the heating temperature was 350°C, the time was 60 minutes, and the atmosphere was nitrogen atmosphere.

Next, the depth direction distribution of donor concentrations in each of the five silicon single crystal substrates after the heating was measured by spreading resistance measurement method (SR method).

Next, a donor concentration (average value of donor concentrations at depths from approximately 60 to 70 um) in a matrix (deep region where the donor concentration was substantially uniform) was subtracted from the measured donor concentrations $N_D(x)$ at depths x. Thereby, donor increments $\Delta N_D(x)$ at the depths x were obtained. Further, a donor increment at a depth of the maximum donor increment attained was determined (maximum donor increment).

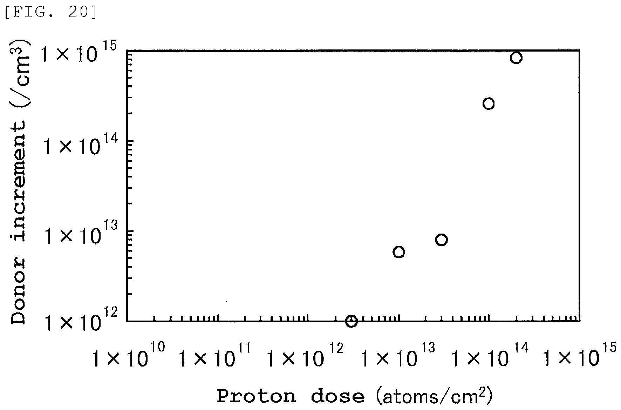

FIG. 20 shows a relation between the proton doses and each maximum donor increment determined as described above. From this result, the proton dose was obtained at which the donor increment would reach the target value (approximately $3\times10^{14}$/cm$^3$). As a result, the proton dose was $1\times10^{14}$ atoms/cm$^2$.

Next, the prepared control-target silicon single crystal substrate was irradiated with protons at a dose of $1\times10^{14}$ atoms/cm$^2$. The proton acceleration voltage was 8 MV.

Next, the control-target silicon single crystal substrate irradiated with protons was heated. In this event, the heating temperature was 350°C, the time was 60 minutes, and the atmosphere was nitrogen atmosphere.

Next, the depth direction distribution of donor concentrations in the heated silicon single crystal substrate was measured by SR method.

Next, a donor concentration (average value of donor concentrations at depths from approximately 60 to 70 um) in a matrix (deep region where the donor concentration was substantially uniform) was subtracted from donor concentrations $N_D(x)$ at the depths x measured in the donor concentration measurement step. Thereby, donor increments $\Delta N_D(x)$ at the depths x were obtained.

As a result of measuring the depth direction distribution of donor increments as described above, the obtained result was substantially the same as that in FIG. 14. This result showed that the donor increment was the target value of approximately $3 \times 10^{14}/cm^3$.

In this manner, although the target donor increment was obtained in Comparative Example 2, since the inventive method for controlling a donor concentration in a silicon single crystal substrate was not employed, the number of test silicon single crystal substrates was large, and the numbers of proton irradiations and donor increment measurements were also large. Thus, more work and cost were required.

As has been described in detail, Comparative Examples 1 and 2 did not employ the inventive method for controlling a donor concentration in a silicon single crystal substrate, so that the number of test silicon single crystal substrates was large, the number of proton irradiations and donor increment measurements were also large, and more work and cost were required.

In contrast, in Examples 1 to 4 employing the inventive method for controlling a donor concentration in a silicon single crystal substrate, the target donor concentrations were obtained at low cost, and it was possible to easily determine proton doses for successfully reducing variation in donor concentration due to silicon single crystal substrates.

It should be noted that the present invention is not limited to the above-described embodiments. The embodiments are just examples, and any embodiments that substantially have the same feature and demonstrate the same functions and effects as those in the technical concept disclosed in claims of the present invention are included in the technical scope of the present invention.


**Claims**

1. A method for controlling a donor concentration in a silicon single crystal substrate by performing:

   a second proton irradiation step of irradiating with protons a silicon single crystal substrate whose donor concentration is to be controlled; and
   a second heat treatment step of heating the silicon single crystal substrate after the second proton irradiation step, so that the donor concentration is controlled,
   wherein the method comprises:

   a first proton irradiation step of irradiating with protons a test silicon single crystal substrate in advance before performing the second proton irradiation step;
   a hydrogen concentration measurement step of measuring a depth direction distribution of hydrogen concentrations in the test silicon single crystal substrate after the first proton irradiation step;
   a first heat treatment step of heating the test silicon single crystal substrate after the first proton irradiation step under conditions as in the second heat treatment step;
   a donor concentration measurement step of measuring a depth direction distribution of donor increments attained in the test silicon single crystal substrate after the first heat treatment step; and
   a correlation acquisition step of acquiring a correlation between the hydrogen concentrations in the test silicon single crystal substrate and the donor increments attained in the test silicon single crystal substrate from the depth direction distribution of the hydrogen concentrations measured in the hydrogen concentration measurement step and the depth direction distribution of the donor increments measured in the donor concentration measurement step,
   wherein a dose of the protons radiated in the second proton irradiation step is adjusted based on the acquired correlation such that a donor increment in the silicon single crystal substrate whose donor concentration is to be controlled reaches a target value after the second heat treatment step.

2. The method for controlling a donor concentration in a silicon single crystal substrate according to claim 1, wherein when the dose of the protons radiated in the second proton irradiation step is adjusted based on the correlation, the dose of the protons in the second proton irradiation step is determined by utilizing:

   a coefficient which is obtained from a dose of the protons in the first proton irradiation step and a maximum hydrogen concentration in the depth direction distribution of the hydrogen concentrations in the test silicon single crystal substrate; and
   a hydrogen concentration which is obtained based on the correlation, and at which the donor increment in the silicon single crystal substrate reaches a target value after the second heat treatment step.

3. The method for controlling a donor concentration in a silicon single crystal substrate according to claim 1 or 2, wherein the dose of the protons in the first proton irradiation step is $1 \times 10^{1q}$ atoms/cm$^2$ or more.

4. The method for controlling a donor concentration in a silicon single crystal substrate according to any one of claims 1 to 3, wherein the dose of the protons radiated in the second proton irradiation step is adjusted for each crystal block.

[FIG. 1]

| Preparation step (test silicon substrate) | S0 |

↓

| First proton irradiation step (test silicon substrate) | S1 |

| Hydrogen concentration measurement step (test silicon substrate) | S2 |

| First heat treatment step (test silicon substrate) | S3 |

| Donor concentration measurement step (test silicon substrate) | S4 |

| Correlation acquisition step (test silicon substrate) | S5 |

↓

| Second proton irradiation step (control-target silicon substrate) | S6 |

↓

| Second heat treatment step (control-target silicon substrate) | S7 |

[FIG. 2]

[FIG. 3]

[FIG. 4]

[FIG. 5]

[FIG. 6]

[FIG. 7]

[FIG. 8]

[FIG. 9]

[FIG. 10]

[FIG. 11]

[FIG. 12]

[FIG. 13]

[FIG. 14]

[FIG. 15]

[FIG. 16]

[FIG. 17]

[FIG. 18]

[FIG. 19]

[FIG. 20]

## INTERNATIONAL SEARCH REPORT

| | International application No. |
|---|---|
| | PCT/JP2021/004559 |

A. CLASSIFICATION OF SUBJECT MATTER
Int. Cl. H01L21/265(2006.01)i, H01L21/66(2006.01)i
FI: H01L21/265 T, H01L21/265 Z, H01L21/265 H, H01L21/265 602A, H01L21/66 L

According to International Patent Classification (IPC) or to both national classification and IPC

B. FIELDS SEARCHED

Minimum documentation searched (classification system followed by classification symbols)
Int. Cl. H01L21/265, H01L21/66

Documentation searched other than minimum documentation to the extent that such documents are included in the fields searched
Published examined utility model applications of Japan       1922-1996
Published unexamined utility model applications of Japan     1971-2021
Registered utility model specifications of Japan             1996-2021
Published registered utility model applications of Japan     1994-2021

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2013/141221 A1 (FUJI ELECTRIC CO., LTD.) 26 September 2013 | 1-4 |
| A | JP 2016-96338 A (INFINEON TECHNOLOGIES AG) 26 May 2016 | 1-4 |
| A | JP 2015-37194 A (INFINEON TECHNOLOGIES AG) 23 February 2015 | 1-4 |
| A | WO 2019/239762 A1 (SHIN-ETSU HANDOTAI CO., LTD.) 19 December 2019 | 1-4 |
| A | JP 2017-63187 A (INFINEON TECHNOLOGIES AG) 30 March 2017 | 1-4 |

☒ Further documents are listed in the continuation of Box C.    ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 01.04.2021 | 13.04.2021 |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

**INTERNATIONAL SEARCH REPORT**

International application No.

PCT/JP2021/004559

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2019-62189 A (INFINEON TECHNOLOGIES AG) 18 April 2019 | 1-4 |
| A | JP 2006-344977 A (INFINEON TECHNOLOGIES AG) 21 December 2006 | 1-4 |
| A | WO 2011/52787 A1 (FUJI ELECTRIC SYSTEMS CO., LTD.) 05 May 2011 | 1-4 |
| A | WO 2007/55352 A1 (FUJI ELECTRIC DEVICE TECHNOLOGY CO., LTD.) 18 May 2007 | 1-4 |

Form PCT/ISA/210 (continuation of second sheet) (January 2015)

| | International application No. |
|---|---|
| | PCT/JP2021/004559 |

| Patent Documents referred to in the Report | Publication Date | Patent Family | Publication Date |
|---|---|---|---|
| WO 2013/141221 A1 | 26.09.2013 | US 2014/0357026 A1<br>EP 2793251 A1<br>CN 104054159 A | |
| JP 2016-96338 A | 26.05.2016 | US 2016/0141399 A1<br>DE 102014116666 A1<br>CN 105609407 A | |
| JP 2015-37194 A | 23.02.2015 | US 2015/0050754 A1<br>DE 102013216195 A1 | |
| WO 2019/239762 A1 | 19.12.2019 | TW 202002116 A | |
| JP 2017-63187 A | 30.03.2017 | US 2017/0062568 A1<br>DE 102015114177 A1 | |
| JP 2019-62189 A | 18.04.2019 | DE 102017118975 A1<br>CN 109411344 A | |
| JP 2006-344977 A | 21.12.2006 | US 2006/0286753 A1<br>DE 102005026408 B3 | |
| WO 2011/52787 A1 | 05.05.2011 | US 2012/0267681 A1<br>CN 102687277 A<br>KR 10-2012-0104537 A | |
| WO 2007/55352 A1 | 18.05.2007 | US 2008/0315364 A1<br>CN 101305470 A | |

Form PCT/ISA/210 (patent family annex) (January 2015)

## REFERENCES CITED IN THE DESCRIPTION

**Patent documents cited in the description**

- JP 3684962 B

- JP 5104314 B

**Non-patent literature cited in the description**

- **H. J. SCHULZE et al.** *Proceedings of the 2016 28th International Symposium on Power Semiconductor Devices and ICs (ISPSD),* 355